# EUROPEAN PATENT APPLICATION

(11) **EP 4 776 767 A1**
(43) Date of publication of application: **15.07.2026**
(21) Application number: 25151470.9
(22) Date of filing: 13.01.2025
(51) Int. Cl.: H05K 7/20

(54) **COOLING DEVICE FOR COOLING AN ELECTRONIC COMPONENT OF AN ELECTRONIC ASSEMBLY OF A MOTOR VEHICLE, ELECTRONIC ASSEMBLY AND MOTOR VEHICLE**

(71) Applicant: Connaught Electronics Ltd., County Galway H54 Y276 (IE)
(72) Inventor: Wujanicz, Stefan, Tuam, H54 Y276 (IE); Cakir, Erim, Tuam, H54 Y276 (IE); Sheik, Malikferoz, 600130 Chennai (IN)
(74) Representative: Jauregui Urbahn, Kristian

(57) **Abstract**

The invention is directed at a cooling device (12) for cooling an electronic component (20) of an electronic assembly (10) of a motor vehicle (42), wherein the cooling device (12) comprises a cooling channel bed (40) for circulating a cooling liquid. The cooling channel bed (40) is formed within a cavity (28), which is at least partially confined by a base plate (24) of the cooling device (12) and by a housing cap (14.1) of a housing (14) of the electronic assembly (10), wherein the housing cap (14.1) comprises a cap plate (14.1.1) and a cap rim (14.1.2), which extends at an angle from the cap plate (14.1.1), wherein for sealing the cavity (28), the base plate (24) and the housing cap (14.1) are connected to one another in a fluid-tight manner on an inner surface of the cap rim (14.1.2).

## Description

The invention is directed at a cooling device for cooling an electronic component of an electronic assembly of a motor vehicle, wherein the cooling device comprises a cooling channel bed for circulating a cooling liquid. A further aspect of the invention is directed at an electronic assembly for a motor vehicle, comprising a cooling device and an electronic component, which is fastened to a printed circuit board of the electronic assembly and which is thermally coupled to the cooling device. A further aspect of the invention is directed at a motor vehicle with an electronic assembly.

As the functionality and computing power of computing systems for vehicles increases, in particular electronic control units (ECUs), domain control units (DCUs) or zone control units (ZPUs), for example for driver assistance systems or other semi-automatic or fully automatic driving functions, the heat dissipation of electronic components increases. It is therefore known to use active cooling solutions by means of a cooling fluid or liquid for these electronic components. These active cooling solutions are usually accompanied by an increased installation space.

Typical liquid-cooled ECUs or the like comprise aluminum casted housing parts with an integrated casted cooling channel bed that has to be sealed, preferably with a welded lid. In other words, in the known arrangements, the cooling channel or cooling channel bed forms part of the casted housing part and is sealed by means of an additional lid, which is welded to the casted housing part. In order to improve cooling efficiency, some designs use embedded copper inserts that are placed in polymer or aluminum housings. Those designs also require additional components, for example plates, to seal the cooling channels. Those plates are often friction stir welded to the cooling channel. In such arrangements, the cooling channel needs to be sealed not only from the outside by placing a sealing plate on top of it, which is welded to it, but also on the bottom side, which comprises the copper insert. That reduces overall reliability, increases assembly complexity and cost.

One object of the present invention is to provide an improved concept for a cooling device with a cooling channel bed and for an associated electronic assembly, which has fewer components, less weight and less complexity.

The object is solved by the subject matters of the independent patent claims. Advantageous further embodiments of the invention are described by the dependent patent claims, the following description and the figures.

A first aspect of the invention is directed at a cooling device for cooling an electronic component of an electronic assembly of a motor vehicle, for example a control device for controlling at least one vehicle function. The cooling device comprises a cooling channel bed for circulating a cooling liquid. In particular, the cooling liquid can be water or an aqueous cooling fluid. The cooling channel bed can comprise one or more cooling channels, which may be separated from each other. The cooling channel bed may additionally or alternatively comprise a plurality of liquid directing elements, for example pins, which may protrude from the cooling channel bed.

According to the invention, the cooling channel bed is formed within a cavity, which is at least partially confined by a base plate of the cooling device and by a housing cap of a housing of the electronic assembly, wherein the housing cap comprises a cap plate and a cap rim, which extends at an angle from the cap plate, wherein for sealing the cavity, the base plate and the housing cap are connected or fastened to one another in a fluid-tight manner on an inner surface of the cap rim. The cap rim may for example extend at an angle of largely ninety degrees from the cap plate.

In other words, the cooling device comprises the base plate, which is connected or fastened to the rim of the housing cap. In particular, the base plate can be welded to the rim of the housing cap. The cavity can be confined by the base plate, the cap plate of the housing cap and the cap rim of the housing cap.

The electronic component to be cooled can be any electronic element that generates waste heat during operation, which must be actively dissipated by the cooling device so that the electronic component does not overheat and become damaged as a result. For example, the electronic element can be an ECU, DCU or ZPU, in particular a computer chip, a processor, an integrated circuit or a system-on-chip (SoC), which can be used in particular for control units of the motor vehicle.

The electronic component may be fastened to a printed circuit board (PCB) of the electronic assembly. In particular, the printed circuit board is not an element of the cooling device, but can merely be fastened to the housing of the electronic assembly, preferably to a bottom part of the housing. The printed circuit board with the electronic component are arranged outside of the cavity, such that the electronic component is thermally coupled to the cooling device, preferably to the base plate of the cooling device. For example, the electronic component may be in contact with the base plate of the cooling device, such that conductive heat flow from the electronic component towards the base plate can take place. The housing can also comprise openings or interfaces so that the printed circuit board can, for example, be signally connected to an electronic interface of the vehicle.

The printed circuit board (PCB) can be designed to carry the electronic component. The printed circuit board is used in particular for mechanical fastening and electrical connection of the electronic component.

In particular, the printed circuit board can carry at least one electronic component, preferably several electronic components, which can generate waste heat during operation, which is to be dissipated by the cooling device.

It is an advantage of the present invention, that there is no need for an additional sealing plate to seal the cavity comprising the cooling channel bed, as the cavity with the cooling channel bed is sealed by the housing cap of the housing of the electronic assembly. The elimination of the additional sealing plate reduces production costs and weight of the electronic assembly and improves its reliability.

Further embodiments of the invention provide additional advantages.

According to an embodiment, the cooling channel bed is provided by the base plate of the cooling device. In other words, the cooling channel bed may be integrated in the base plate. In other words, the cooling liquid may circulate within the cavity, wherein it may be in direct thermal contact with the base plate and with a surface of the housing cap, which faces an interior of the cavity. The cooling channel bed may comprise several indentations and/or protrusions for directing a flow path of the cooling liquid. The indentations and/or protrusions may be formed within the base plate or protruding from a surface of the base plate, which faces the interior of the cavity.

According to a further embodiment, the cooling channel bed comprises at least one heat dissipating element, which extends or protrudes from the base plate into the cavity. As the cooling channel bed may be provided by the base plate of the cooling device, the at least one heat dissipating element may protrude from the surface of the base plate, which faces the interior of the cavity. The at least one heat dissipating element advantageously enlarges the surface of the cooling channel bed, thus improving heat transfer from the electronic component to the cooling device.

In particular, the at least one heat dissipating element may be designed to direct a cooling liquid flow inside the cavity. In other words, the at least one heat dissipating element may improve a circulation of the cooling liquid within the cavity. The cooling channel bed may comprise one or more cooling channels, which may be separated from each other by walls. The walls may extend or protrude from the cooling channel bed. The at least one heat dissipating element may form part of such a wall. The wall may extend or protrude from the base plate, which may provide the cooling channel bed. In other words, the cooling channel bed may comprise the one or more cooling channels. Both, the cooling channel bed and the cooling channels, may be provided by or integrated in the base plate.

According to a further embodiment, the at least one heat dissipating element is one of the following: a rib, a fin, a pin, a notch, an indentation or a combination thereof. There may also be a plurality of heat dissipating elements, which may be of the same kind or of different kinds. In other words, there may for example be a plurality of fins, which may be arranged largely in parallel along the surface of the base plate. Those parallel aligned fins may form one or more cooling channels on the surface of the base plate for circulating the cooling liquid.

According to a further embodiment, the base plate comprises a pedestal for thermally contacting the cooling device to the electronic component. The pedestal is arranged outside the cavity. The pedestal and the base plate may be formed as one piece. In other words, the base plate and the pedestal may be made of the same material. The pedestal may have a geometric shape, which corresponds to a geometric shape of the electronic component to be cooled. In an assembled state, the pedestal may be in direct and/or in thermal contact with the electronic component or a surface thereof.

In particular, the at least one heat dissipating element and the pedestal extend from opposite sides of the base plate, the heat dissipating element extending into the cavity and the pedestal extending towards the electronic component, which is arranged on the printed circuit board outside the cavity. The base plate, the at least one heat dissipating element and the pedestal may be formed as one piece from the same material, which preferably is a material with higher thermal conductivity than aluminum.

In particular, a sheet or layer of thermal interface material is arranged between the electronic component and the pedestal. The thermal interface material may be a thermally conductive paste, which further improves heat transfer from the electronic component towards the cooling device.

According to a further embodiment, the base plate and/or the at least one heat dissipating element and/or the pedestal are at least partially, in particular entirely, made of copper.

In particular, the housing cap is at least partially made of aluminum and/or a polymer. Preferably, the cap rim is made from a polymer. Preferably, the housing cap is at least in parts an injection molded component. The use of a polymer for the housing cap in total and/or at least for the cap rim is advantageous in that it reduces weight and cost for producing the electronic assembly. Further, as the base plate, which is preferably made from copper, is fastened to the cap rim, galvanic corrosion issues, which occur in copper-to-aluminum joints, can be eliminated.

Preferably, the housing cap, in particular the cap rim, comprises an inlet and an outlet for the cooling liquid. In other words, the one or more cooling channels of the cooling bed may be fluidically connected to the inlet and/or the outlet in the cap rim. Thus, cooling liquid may be fed into the one or more cooling channels and extracted from the one or more cooling channels. As a result, the cooling liquid, which is cooled in particular, can advantageously be introduced into the inlet of the cap rim, whereby the cooling liquid can be directed into the one or more cooling channels. In addition, the heated cooling liquid in particular can advantageously be discharged from the outlet of the cap rim, whereby the cooling liquid can be directed out of the one or more cooling channels.

The inlet and the outlet can, for example, be fluidically connected to an interface of a cooling system of the motor vehicle, wherein the cooling system can comprise, for example, a heat exchanger for the cooling liquid, a liquid pump or a liquid compressor, a reservoir and/or an expansion tank for the cooling liquid, as well as an associated electronic control device.

In at least one embodiment, it is provided that the inlet and the outlet are formed on a common side of the cap rim. As a result, the cooling device can be connected fluidically to complementary interfaces of a cooling system correspondingly easily, in particular by only a single docking process for the inlet and the outlet.

In at least one embodiment of the cooling device, it is provided that a first cooling channel inlet of a first cooling channel and a second cooling channel inlet of a second cooling channel are fluidically connected in parallel to the inlet of the cap rim via an inlet connection channel. This allows the cooled cooling liquid to be advantageously distributed through the inlet, preferably evenly, to the cooling channels. In particular, an even distribution of the cooling capacity can thus be distributed to the cooling device.

In particular, the inlet connection channel can act as an inlet liquid distributor, by means of which the incoming cooled cooling liquid can be distributed to the cooling channels simultaneously. Here, "parallel" can be understood to mean that the inlet can be connected both directly to the first cooling channel inlet and directly to the second cooling channel inlet.

In particular, the inlet and the inlet connection channel can virtually form a T-piece or a Y-piece, within which the cooled cooling liquid can be divided between the cooling channels.

In at least one embodiment, it is provided that a first cooling channel outlet of the first cooling channel and a second cooling channel outlet of the second cooling channel are fluidically connected in parallel to the outlet via an outlet connection channel.

In particular, the outlet connection channel can act as an outlet liquid connector, by means of which the heated cooling liquid flowing out of the respective cooling channel outlets can be brought together and guided to the outlet at the same time. By "parallel" it can be understood here that the outlet can be connected both directly to the first cooling channel outlet and directly to the second cooling channel outlet.

In particular, the outlet and the outlet connection channel can form a kind of T-piece or Y-piece, within which the heated cooling liquid from the two cooling channels can be brought together.

In at least one embodiment, it is provided that the inlet connection channel is a first through-hole through the cap rim and/or the outlet connection channel is a separate, second through-hole through the cap rim. This makes it particularly easy to provide the inlet connection channel and/or the outlet connection channel in the cap rim of the housing cap.

A through-hole is a hole that passes completely through a component, in particular through the cap rim of the housing cap. In particular, the through-hole may have been drilled into a main body of the cap rim using a drill. This advantageously requires little effort and is also not complex. The inlet and outlet of the housing can be fluidically connected to the through-hole.

The invention also includes combinations of the features of the described embodiments.

A further aspect of the invention is directed at an electronic assembly for a motor vehicle, comprising
- a housing with a bottom housing part and a housing cap with a cap plate and a cap rim extending at an angle from the cap plate, wherein the bottom housing part and the housing cap confine an interior of the housing,
- a printed circuit board, which is fastened to the housing,
- a cooling device according to one of the preceding claims, comprising a base plate, which is connected to an inner surface of the cap rim in a fluid-tight manner, wherein the base plate and the housing cap at least partially confine a cavity, comprising a cooling channel bed for circulating a cooling liquid, and
- an electronic component, which is fastened to the printed circuit board and which is thermally coupled to the cooling device.

According to an embodiment, the bottom housing part is cast from aluminum, the housing cap, preferably only the cap rim, is made from a polymer and the base plate, which provides the cooling channel bed, is made from copper.

According to at least one embodiment, it is provided that the electronic assembly is a control unit, in particular an electronic control unit (ECU), which can preferably be used for motor vehicles.

In particular, a vehicle-centric, zone-oriented architecture of the electrical or electronic components of the motor vehicle can be provided for the motor vehicle. In particular, at least one main controller, for example a single main controller, can be provided in such a vehicle architecture, which can also be referred to as the main control unit or vehicle computer, and which can be designed to perform the main computing operations for vehicle-specific applications, for example autonomous driving.

The main controller may be connected to several, preferably four, zonal controllers, which may also be referred to as zone controllers, by means of signaling technology. Zonal controllers can be designed to perform less demanding computing operations compared to the main computing operations of the main controller.

For example, the electronic vehicle architecture can be divided into zones, preferably four zones, wherein a zonal controller can be provided for each zone. In particular, the main controller can be connected via the zonal controllers to other electrical and electronic components of the motor vehicle, in particular to smaller, distributed control units, as well as to a large number of sensors and actuators of the motor vehicle.

Such a vehicle-centric, zone-oriented architecture of the electrical or electronic components can be advantageous at least to the extent that they are less complex than domain-oriented architectures. In particular, the computing operations of the complex, vehicle-specific applications of distributed control units can be consolidated on a single or on a few, very powerful main controllers.

Preferably, the electronic assembly according to the invention can be a main controller of the motor vehicle. Alternatively, the electronic assembly according to the invention may be a zonal controller of the motor vehicle. Accordingly, the cooling device according to the invention can be provided for cooling the powerful electronic components of a main controller or a zonal controller.

The electronic component may in particular be a component of the ECU, in particular a SoC, a microchip, a processor, an integrated circuit or the like, wherein the powerful electronic component generates harmful waste heat during operation, which must be dissipated by means of the cooling device.

A further aspect of the invention relates to a motor vehicle with at least one electronic assembly according to the invention.

Further embodiments of the electronic assembly and/or the motor vehicle according to the invention follow directly from the various embodiments of the cooling device according to the invention and vice versa. In particular, individual features and corresponding explanations as well as advantages relating to the various implementations of the cooling device according to the invention can be transferred analogously to implementations of the electronic assembly and/or the motor vehicle according to the invention and vice versa.

Further features of the invention are apparent from the claims, the figures and the figure description. The features and combinations of features mentioned above in the description as well as the features and combinations of features mentioned below in the description of figures and/or shown in the figures may be comprised by the invention not only in the respective combination stated, but also in other combinations. In particular, embodiments and combinations of features, which do not have all the features of an originally formulated claim, may also be comprised by the invention. Moreover, embodiments and combinations of features, which go beyond or deviate from the combinations of features set forth in the recitations of the claims may be comprised by the invention.

In the following, the invention will be explained in detail with reference to specific exemplary implementations and respective schematic drawings. In the drawings, identical or functionally identical elements may be denoted by the same reference signs. The description of identical or functionally identical elements is not necessarily repeated with respect to different figures.

Embodiments of the invention are described below. In the figures:
- Fig. 1: Shows a schematic view of an electronic assembly with a cooling device as known from the art;
- Fig. 2: Shows a schematic view of an electronic assembly with a cooling device according to an embodiment of the invention;
- Fig. 3: Shows a schematic outside view of an electronic assembly according to an embodiment of the invention;
- Fig. 4: Shows a schematic inside view of an electronic assembly according to a first embodiment of the invention;
- Fig. 5: Shows a schematic longitudinal section view of an electronic assembly according to the first embodiment of the invention;
- Fig. 6: Shows a schematic inside view of an electronic assembly according to a second embodiment of the invention;
- Fig. 7: Shows a schematic longitudinal section view of an electronic assembly according to the second embodiment of the invention; and
- Fig. 8: Shows a schematic view of a motor vehicle with an electronic assembly according to an embodiment of the invention.

The embodiments explained below are preferred embodiments of the invention. In the embodiments, the described components of the embodiments each represent individual features of the invention which are to be considered independently of each other, which also further form the invention independently of each other and are thus also to be regarded as part of the invention individually or in a combination other than that shown. Furthermore, the embodiment described can also be supplemented by other features of the invention already described.

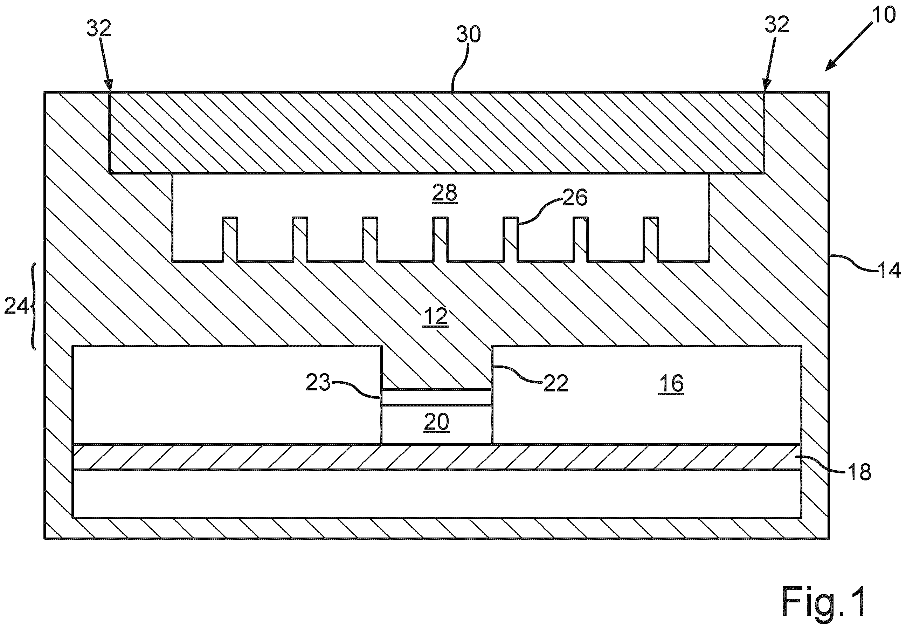

Fig. 1 shows a schematic view of an electronic assembly 10 with a cooling device 12 as known from the art. The example shows a housing 14 of the electronic assembly 10, wherein the housing 14 may preferably be cast from aluminum. The housing 14 provides or confines an interior or an interior space 16 of the housing 14. In the housing interior 16, a printed circuit board 18 may be arranged, which may be fastened to a surface of the housing 14, which faces the housing interior 16.

In the shown example, the printed circuit board 18 carries an electronic component 20, for example an ECU, DCU or ZPU, in particular a computer chip, a processor, an integrated circuit or a system-on-chip (SoC), which can be used in particular for control units of motor vehicles. Due to its high computing power, the electronic component 20 may dissipate heat, for example equivalent to 200 Watts or more. The electronic component 20 therefor needs cooling.

In the prior art solution shown in Fig. 1, cooling is accommodated by the cooling device 12. To do so, the electronic component 20 is thermally coupled to a pedestal 22 of the cooling device 12, which forms an integral part of the housing 14 of the electronic assembly 10. Between the electronic component 20 and the pedestal 22, there may be arranged a thin layer of thermal interface material 23. In other words, according to the known solution, the cooling device 12 is provided by the housing 14. In other words, the contacting surface of the pedestal 22 of the cooling device 12 is made of the same material as the housing 14, in most cases aluminum.

The pedestal 22 extends away from a base plate 24 of the cooling device 12. On an opposite side of the base plate 24, several heat dissipating elements 26 may be arranged. The heat dissipating elements 26 may extend into a cavity 28, which may be partially confined by the housing 14. Inside the cavity 28, a cooling liquid (not shown) may circulate. The cavity 28 may be sealed by a sealing plate 30, which may be welded to the housing 14. The welded spots or welded seams are indicated in Fig. 1 by reference signs 32. The sealing plate 30 may be made from aluminum, as the housing 14. It may also be made from copper for improved heat transfer. In the latter case, corrosion problems may occur at the welded spots or welded seams 32, especially as they are open to the outside of the electronic assembly 10, as shown in Fig. 1.

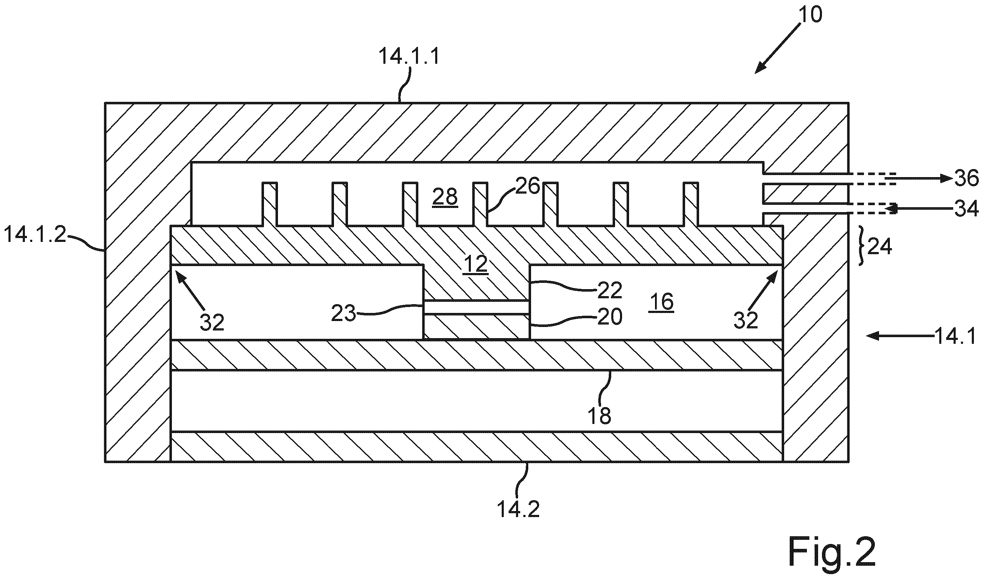

Fig. 2 shows a schematic view of an electronic assembly 10 according to an embodiment of the invention. The electronic assembly 10 also comprises a housing 14 with a housing cap 14.1 and a bottom housing part 14.2. The housing cap 14.1 comprises a cap plate 14.1.1 and a cap rim 14.1.2. The cap rim 14.1.2 extends at an angle from the cap plate 14.1.1. The angle may measure ninety degrees. In an assembled state, the housing cap 14.1 and the bottom housing part 14.2 confined an interior 16 of the housing 14.

In the housing interior 16, a printed circuit board 18 may be arranged. As described in the context of Fig. 1, the printed circuit board 18 may carry an electronic component 20, which may be an ECU, DCU or ZPU, in particular a computer chip, a processor, an integrated circuit or a system-on-chip (SoC), which can be used in particular for control units of motor vehicles. Due to its high computing power, the electronic component 20 may dissipate heat, for example equivalent to 200 Watts or more. The electronic component 20 therefor needs cooling.

According to the embodiment of the invention as presented in Fig. 2, cooling of the electronic component 20 is achieved by a cooling device 12, which does not form part of the housing 14, in contrast to the known solution as shown in Fig. 1. The cooling device 12 as shown in Fig. 2 comprises a base plate 24, which is fastened to an inner surface of the cap rim 14.1.2, as indicated by reference sign 32, which refer to the welded spots or welded seams of the welded joint between the base plate 24 and the inner surface of the cap rim 14.1.2. The base plate 24 may be made from copper.

In an assembled state, the base plate 24 and the housing cap 14.1 confine a cavity 28. The base plate 24 comprises a pedestal 22 and a plurality of heat dissipating elements 26, wherein the pedestal 22 extends away from the base plate 24 towards the interior 16 of the housing 14. The plurality of heat dissipating elements 26 extend away from an opposite side of the base plate 24 into the cavity 28. The pedestal 22 is in thermal contact with the electronic component 20, wherein a sheet of thermal interface material 23 is arranged between the electronic component 20 and the pedestal 22.

Inside the cavity, one or more cooling channels may be formed, for example by the plurality of heat dissipating elements 26. A cooling liquid may circulate inside the one or more cooling channels. The cooling liquid may be fed into the one or more cooling channels via an inlet 34, which may be formed as a through-hole in the cap rim 14.1.2. Warmed or heated cooling liquid may be extracted from the one or more cooling channels via an outlet 36, which may also be formed as a through-hole in the cap rim 14.1.2. The inlet 34 and the outlet 36 may be formed in the same side surface of the cap rim 14.1.2. They may alternatively be formed on opposite side surfaces of the cap rim 14.1.2.

The embodiment of Fig. 2 is especially advantageous over the known solution of Fig. 1, as the welded spots or welded seams 32 according to the embodiment as shown in Fig. 2 lie within the interior 16 of the housing 14. In this way, they are protected from an outside environment of the housing 14.

The cap rim 14.1.2 may be made from a polymer. Thus, corrosion problems at the welded spots or welded seams 32 may be avoided.

With reference to the components, which are explained in detail with regard to Fig. 2, Figs. 3 to 7 show schematic views of further exemplary embodiments of an electronic assembly 10.

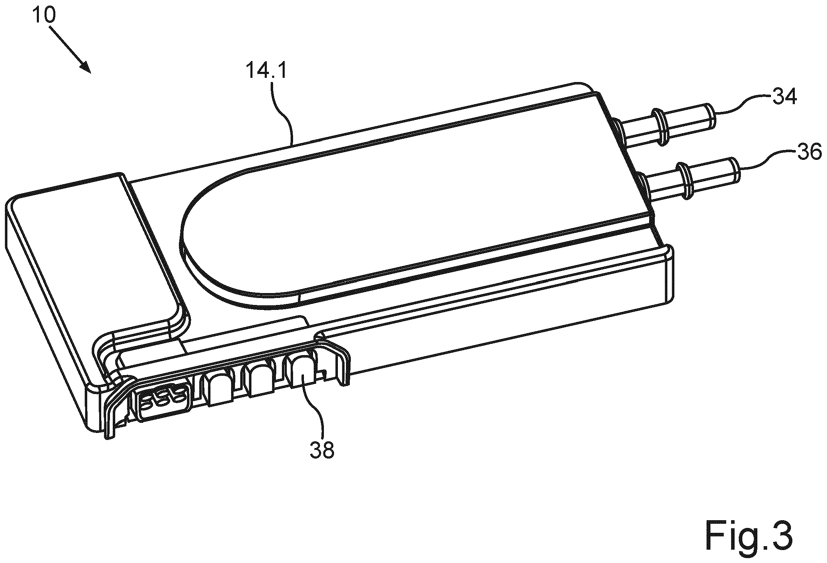

Fig. 3 shows a schematic outside view of an electronic assembly 10. The electronic assembly 10 comprises a housing 14 with a housing cap 14.1. The bottom housing part 14.2 is not shown in the perspective view of Fig. 3. The housing cap 14.1 may at least partially be formed from a polymer in an injection molding manufacturing step. A cooling liquid inlet 34 and a cooling liquid outlet 36 may be formed in a side wall of the cap rim 14.1.2 of the housing cap 14.1. The housing 14 may also provide several through-holes for electric interfaces 38 to electrically connect the printed circuit board 18 inside the housing 14 to other electric or electronic components of a motor vehicle.

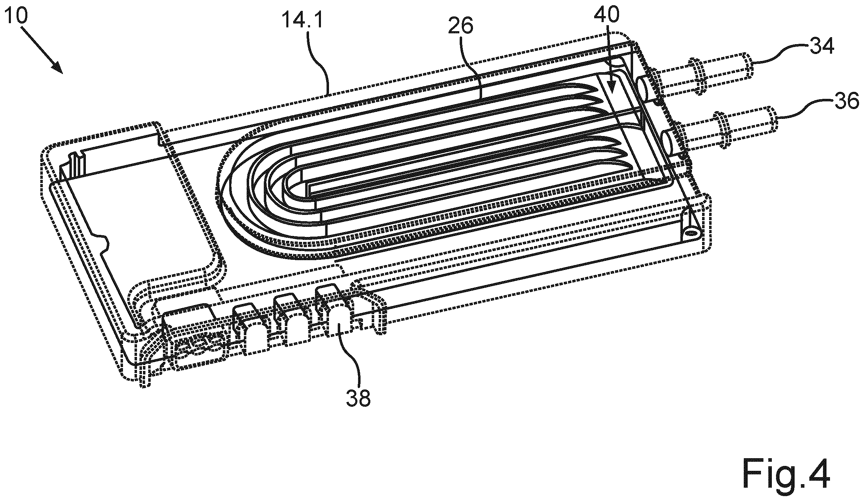

Fig. 4 shows a schematic outside view of an electronic assembly 10. The housing cap 14.1 of Fig. 4 is shown in a half-transparent view, in order to be able to show the interior of the cavity 28, comprising the cooling channel bed 40, which is provided by the base plate 24, and the heat dissipating elements 26, which extend away from it into the cavity 28. In the shown example, the heat dissipating elements 26 are formed as elongated fins, which are arranged in parallel and which form a U-shape inside the cavity 28. Like this, cooling liquid can efficiently be guided through the cavity 28 from the inlet 34 to the outlet 36.

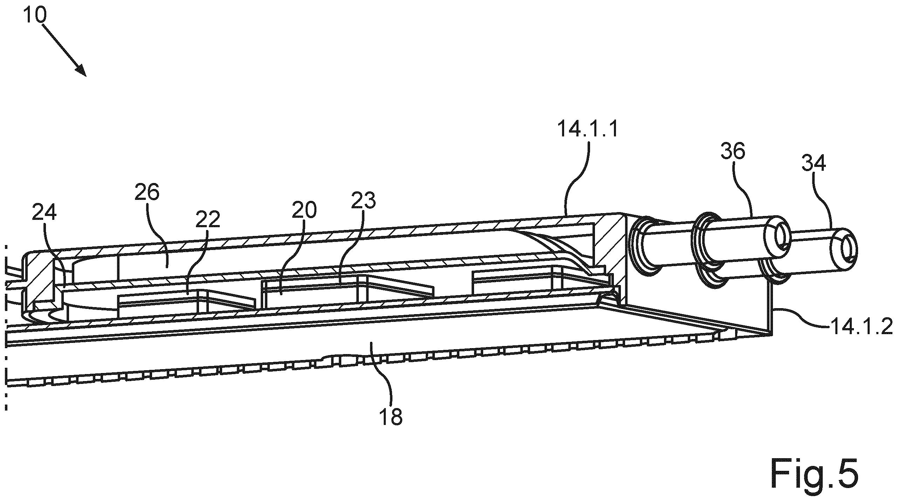

Fig. 5 shows a schematic cross sectional view of the embodiment according to Fig. 4. For clarity, the bottom housing part 14.2 is not shown. Fig. 5 shows the printed circuit board 18, which is fastened to the cap rim 14.1.2. The printed circuit board 18 carries the electronic component 20, which is to be cooled. On top of the electronic component 20, a thin sheet of thermal interface material 23 is arranged. On top of the thermal interface material 23, a pedestal 22 of the cooling device 12 is arranged. The pedestal 22 is in thermal contact with the electronic component 20. The pedestal 22 extends from a base plate 24 of the cooling device 12 in the direction of the electronic component 20, while the fin-like heat dissipating elements 26 extend from the base plate 24 on an opposite side thereof.

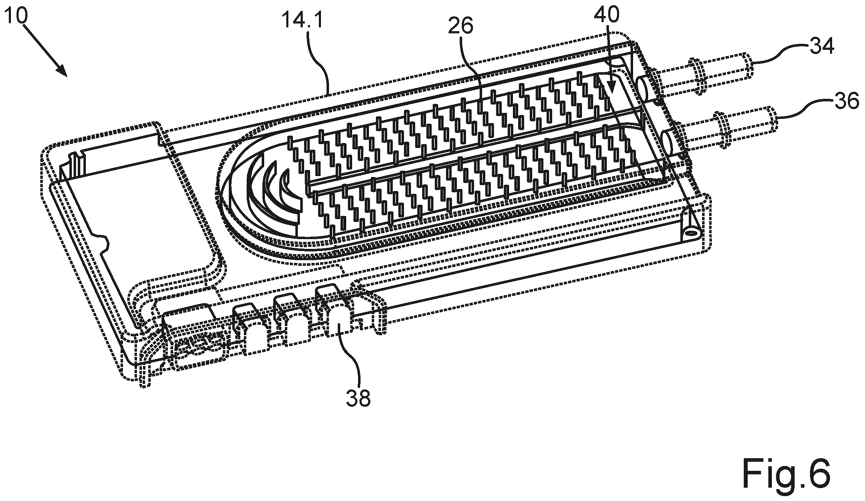

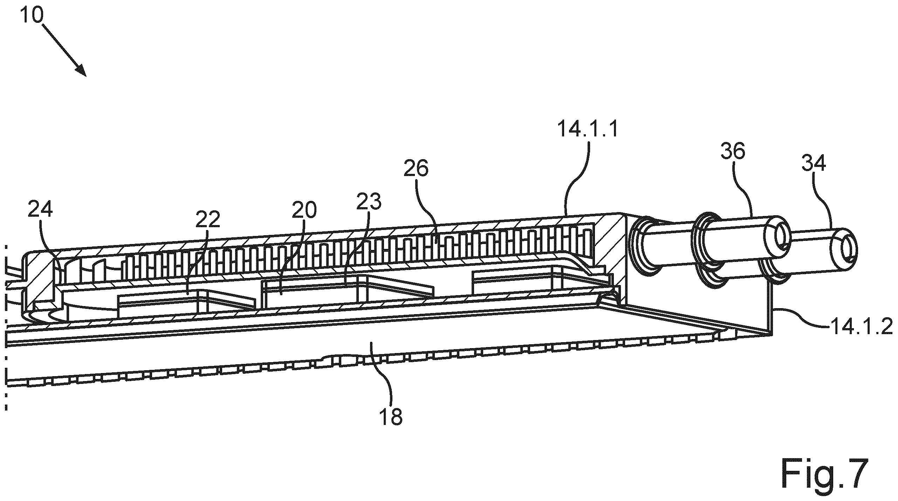

Figs. 6 and 7 shows arrangements, which are comparable to Figs. 4 and 5, respectively, wherein the heat dissipating elements 26 are formed as a combination of pins and fin-like elements for a more flexible dissipation of cooling liquid within the cavity 28. Of course, any other combination of heat dissipating elements 26 is possible and can be chosen according to cooling needs.

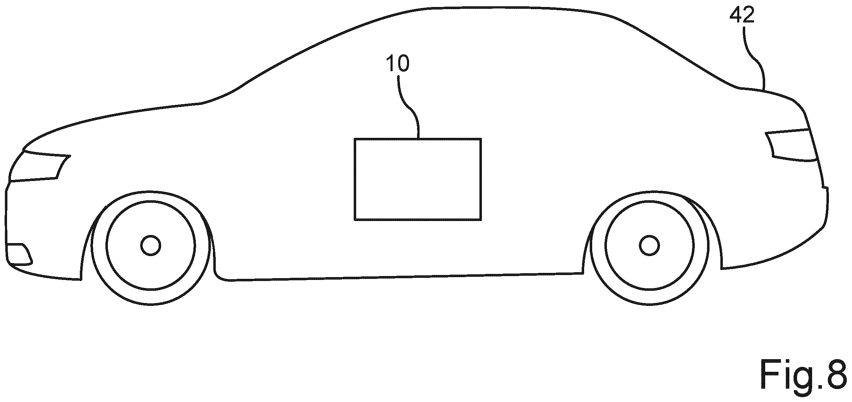

Fig. 8 shows a schematic view of a motor vehicle 42 with an electronic assembly 10 according to an embodiment of the present invention. The electronic assembly 10 may for example be a control device for controlling at least one vehicle function of the motor vehicle 42.

Typical liquid-cooled ECUs consist of aluminum casted housing parts with a casted cooling channel that has to be sealed with a welded lid. In order to improve cooling efficiency, some designs use embedded copper inserts that are placed in polymer or aluminum housings. Those designs still require friction stir welded (FSW - friction stir welding) plates to seal cooling channels. That means that the cooling channel of traditional liquid cooled ECUs needs to be sealed from two sides: FSW from the top and copper insert from the bottom. That reduces overall reliability, increases assembly complexity and cost.

The present invention introduces a range of advantages over traditional liquid cooled ECUs:
1. Maximized thermal performance provided by cooling channel bed preferably made from copper;
2. Possible elimination of FSW plate;
3. Cooling channel bed with pins and/or fins is preferably made from copper and is sealed to the housing part - that allows for excellent heat spreading effect and improved thermal performance;
4. Injection molded upper housing minimizes manufacturing cost, weight and eliminates the problem of galvanic corrosion between aluminum and copper parts;
5. Improved reliability of the ECU as only two parts have to be bonded / joined / glued.

As described, ECU, Domain Controller and/or any other device that includes high power components requires liquid cooling. Most demanding applications reach a physical limit of aluminum housings and cooling channel features. The present invention includes using a copper plate with pins and/or fins that is used as a cooling channel bed. That eliminates the need of using an additional FSW lid to seal the cooling channel. Elimination of FSW plate allows for cost savings and improves reliability of the DC / ECU.

Upper housing part may be made from polymer to reduce the weight, cost and eliminate galvanic corrosion issues that would occur in copper-to-aluminum joints. Additionally, the entire cooling channel bed may be made from copper, which drastically improves thermal efficiency of the design, pushing the boundaries set by traditional aluminum channels.

Overall, the examples show, how an improved concept for a cooling device with a cooling channel bed and for an associated electronic assembly, which has fewer components, less weight and less complexity can be provided.

## Claims

1. Cooling device (12) for cooling an electronic component (20) of an electronic assembly (10) of a motor vehicle (42), wherein the cooling device (12) comprises a cooling channel bed (40) for circulating a cooling liquid,
**characterized in that**
the cooling channel bed (40) is formed within a cavity (28), which is at least partially confined by a base plate (24) of the cooling device (12) and by a housing cap (14.1) of a housing (14) of the electronic assembly (10), wherein the housing cap (14.1) comprises a cap plate (14.1.1) and a cap rim (14.1.2), which extends at an angle from the cap plate (14.1.1), wherein for sealing the cavity (28), the base plate (24) and the housing cap (14.1) are connected to one another in a fluid-tight manner on an inner surface of the cap rim (14.1.2).

2. Cooling device (12) according to claim 1, wherein the cooling channel bed (40) is provided by the base plate (24) of the cooling device (12).

3. Cooling device (12) according to claim 2, wherein the cooling channel bed (40) comprises at least one heat dissipating element (26), which extends from the base plate (24) into the cavity (28).

4. Cooling device (12) according to claim 3, wherein the at least one heat dissipating element (26) is designed to direct a cooling liquid flow inside the cavity (28).

5. Cooling device (12) according to one of claims 3 or 4, wherein the at least one heat dissipating element (26) is one of the following: a rib, a fin, a pin, a notch, an indentation or a combination thereof.

6. Cooling device (12) according to any of the preceding claims, wherein the base plate (24) comprises a pedestal (22) for thermally contacting the cooling device (12) to the electronic component (20).

7. Cooling device (12) according to any of claims 3 to 5 and 6, wherein the at least one heat dissipating element (26) and the pedestal (22) extend from opposite sides of the base plate (24), the at least one heat dissipating element (26) extending into the cavity (28) and the pedestal (22) extending towards the electronic component (20), which is arranged on a printed circuit board (18) of the electronic assembly (10) outside the cavity (28).

8. Cooling device (12) according to any of claims 6 or 7, wherein a layer of thermal interface material (23) is arranged between the electronic component (20) and the pedestal (22).

9. Cooling device (12) according to any of the preceding claims, wherein the base plate (24) and/or the at least one heat dissipating element (26) and/or the pedestal (22) are at least partially, in particular entirely, made of copper.

10. Cooling device (12) according to any of the preceding claims, wherein the housing cap (14.1) is at least partially made of aluminum and/or a polymer.

11. Cooling device (12) according to claim 10, wherein the housing cap (14.1) is at least in parts an injection molded component.

12. Cooling device (12) according to any of the preceding claims, wherein the housing cap (14.1), in particular the cap rim (14.1.2), comprises an inlet (34) and an outlet (36) for the cooling liquid.

13. Electronic assembly (10) for a motor vehicle (42), comprising
- a housing (14) with a bottom housing part (14.2) and a housing cap (14.1) with a cap plate (14.1.1) and a cap rim (14.1.2) extending at an angle from the cap plate (14.1.1), wherein the bottom housing part (14.2) and the housing cap (14.1) confine an interior (16) of the housing (14),
- a printed circuit board (18), which is fastened to the housing (14),
- a cooling device (12) according to one of the preceding claims, comprising a base plate (24), which is connected to an inner surface of the cap rim (14.1.2) in a fluid-tight manner, wherein the base plate (24) and the housing cap (14.1) at least partially confine a cavity (28), comprising a cooling channel bed (40) for circulating a cooling liquid, and
- an electronic component (20), which is fastened to the printed circuit board (18) and which is thermally coupled to the cooling device (12).

14. Electronic assembly (10) according to claim 13, wherein the electronic assembly (10) is or forms part of a control device for controlling at least one vehicle function of the motor vehicle (42).

15. Motor vehicle (42), comprising an electronic assembly (10) according to any of claims 13 to 14.
